# EUROPEAN PATENT APPLICATION

(11) **EP 4 442 785 A1**
(43) Date of publication of application: **09.10.2024**
(21) Application number: 22901138.2
(22) Date of filing: 21.11.2022
(51) Int. Cl.: C09J 183/04, C09J 183/05, C09J 183/07, C09J 183/14, H01L 21/02

(54) **RELEASABILITY IMPARTER, ADHESIVE COMPOSITION, LAYERED PRODUCT, AND METHOD FOR PRODUCING SEMICONDUCTOR SUBSTRATE**

(30) Priority: 01.12.2021 JP 2021195630
(71) Applicant: Nissan Chemical Corporation, Tokyo 103-6119 (JP)
(72) Inventor: FUKUDA Takuya, Toyama-shi, Toyama 939-2792 (JP); SHINJO Tetsuya, Toyama-shi, Toyama 939-2792 (JP)
(74) Representative: Hoffmann Eitle
(86) International application number: PCT/JP2022/043009
(87) International publication number: WO 2023/100705

(57) **Abstract**

An adhesive composition including a polymer having an amide bond and a polyorganosiloxane structure.

## Description

### Technical Field

The present invention relates to a releasability-imparting agent, an adhesive composition, a laminate, a method for producing a laminate, and a method for producing a semiconductor substrate.

### Background Art

Conventionally, semiconductor wafers have been integrated in a two-dimensional planar direction. For the purpose of further integration, a semiconductor integration technology in which the plane is further integrated (laminated) in a three-dimensional direction has been required. This three-dimensional lamination is a technique of integrating multiple layers while being connected with a through silicon via (TSV). At the time of integrating multiple layers, each wafer to be integrated is thinned by polishing on the side opposite to the formed circuit surface (that is, the back surface), and the thinned semiconductor wafers are laminated.

A semiconductor wafer before thinning (also referred to herein simply as a wafer) is bonded to a support for polishing with a polishing apparatus.

The adhesion at this time is referred to as temporary adhesion because it must be easily released after polishing. This temporary adhesion must be easily removed from the support. When a large force is applied to the removal, the thinned semiconductor wafer may be cut or deformed. The removal is easily performed such that the situation does not occur. However, at the time of polishing the back surface of a semiconductor wafer, it is not preferable that the semiconductor wafer is detached or displaced due to polishing stress. Therefore, the performance required for temporary adhesion is to withstand the stress during polishing and to be easily removed after polishing.

For example, there is a demand for a performance having a high stress (strong adhesive force) in the planar direction at the time of polishing and having a low stress (weak adhesive force) in the longitudinal direction at the time of removal.

Under the above-described circumstances, as an adhesive composition capable of realizing such temporary adhesion, the inventors have reported adhesive compositions containing components such as polydimethylsiloxane, in addition to a component that is cured by hydrosilylation reaction (See, for example, Patent Literatures 1 and 2.).

After the semiconductor wafer and the support are released from each other, the adhesive layer left on the semiconductor wafer is dissolved and removed by, for example, a cleaning agent composition (cleaning liquid).

### Citation List

### Patent Literature

Patent Literature 1: WO 2017/221772 A1
Patent Literature 2: WO 2018/216732 A1

### Summary of Invention

### Technical Problem

Dissolution and removal with a cleaning agent composition takes more time as more adhesive layer is left on the semiconductor substrate. Therefore, a method capable of removing the adhesive layer in a short time is required.

In addition, conventional adhesive compositions contain release components in a large amount, and have a concern about the mechanical strength of the adhesive layer and the storage stability of the adhesive composition. Therefore, there is a demand for an adhesive composition that is expected to have sufficient adhesion and release effect when a release component is added in a small amount.

The present invention has been made in view of the above circumstances, and an object of the present invention is to provide an adhesive composition capable of forming an adhesive layer that can be removed in a short time even when more adhesive layer is left on the semiconductor substrate. In addition, an object of the present invention is to provide a releasability-imparting agent capable of exhibiting sufficient adhesion and a release and removal effect in a cleaning step when a small amount thereof is added. Further, an object of the present invention is to provide a laminate having an adhesive layer formed from the adhesive composition, a method for producing a semiconductor substrate using the laminate, and a method for producing the laminate.

### Solution to Problem

As a result of intensive studies to solve the above-described problems, the present inventors have found that the above-described problems can be solved by including a polymer having an amide bond and a polyorganosiloxane structure into an adhesive composition, and have completed the present invention.

That is, the present invention includes the following aspects.
[1] An adhesive composition including a polymer having an amide bond and a polyorganosiloxane structure.
[2] The adhesive composition according to [1], wherein the polymer has the amide bond in a main chain.
[3] The adhesive composition according to [1] or [2], wherein the polymer has the polyorganosiloxane structure in a main chain.
[4] The adhesive composition according to any one of [1] to [3], wherein the polyorganosiloxane structure is represented by a formula (1) below: 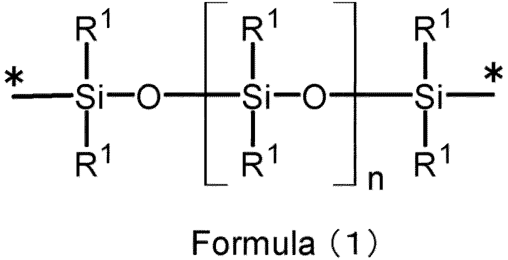 wherein, in the formula (1), R¹ each independently represents an alkyl group having 1 to 4 carbon atoms or a phenyl group, n represents a repeating unit number and is a positive integer, and * represents a bonding hand.
[5] The adhesive composition according to [4], wherein, in the formula (1), R¹ represents a methyl group.
[6] The adhesive composition according to any one of [1] to [5], further including an adhesive component.
[7] The adhesive composition according to [6], wherein the adhesive component includes a component that is cured by hydrosilylation reaction.
[8] The adhesive composition according to [7], wherein the component that is cured by hydrosilylation reaction includes a polyorganosiloxane component that is cured by hydrosilylation reaction.
[9] The adhesive composition according to [8], wherein
   the polyorganosiloxane component that is cured by hydrosilylation reaction includes:
   a polyorganosiloxane (a1) having an alkenyl group bonded to a silicon atom and having 2 to 40 carbon atoms;
   a polyorganosiloxane (a2) having an Si-H group; and
   a platinum group metal-based catalyst (A2).
[10] A laminate including: an adhesive layer interposed between a semiconductor substrate and a support substrate and in contact with the semiconductor substrate, wherein
   the adhesive layer is formed from the adhesive composition according to any one of [1] to [9].
[11] The laminate according to [10], including: a release layer interposed between the semiconductor substrate and the support substrate and in contact with the support substrate and the adhesive layer.
[12] A method for producing a semiconductor substrate, the method including:
   a step of processing the semiconductor substrate in the laminate according to [10] or [11]; and
   a step of separating the support substrate and the processed semiconductor substrate from each other.
[13] A method for producing the laminate according to [10], the method including:
   a step of forming an adhesive coating layer that provides the adhesive layer; and
   a step of heating the adhesive coating layer to form the adhesive layer.
[14] A releasability-imparting agent used in an adhesive composition,
   the releasability-imparting agent being a polymer having an amide bond and a polyorganosiloxane structure.
[15] The releasability-imparting agent according to [14], wherein the polymer has the amide bond in a main chain.
[16] The releasability-imparting agent according to [14] or [15], wherein the polymer has the polyorganosiloxane structure in a main chain.
[17] The releasability-imparting agent according to any one of [14] to [16], wherein the polyorganosiloxane structure is represented by a formula (1) below: 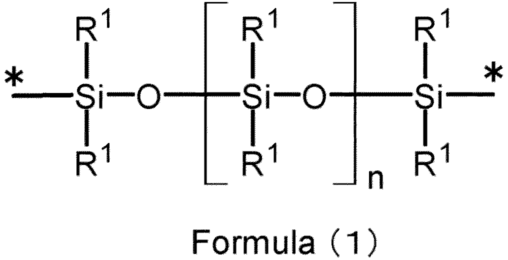 wherein, in the formula (1), R¹ each independently represents an alkyl group having 1 to 4 carbon atoms or a phenyl group, n represents a repeating unit number and is a positive integer, and * represents a bonding hand.
[18] The releasability-imparting agent according to [17], wherein, in the formula (1), R¹ represents a methyl group.

### Advantageous Effects of Invention

According to the present invention, it is possible to provide an adhesive composition capable of forming an adhesive layer that can be removed in a short time even when more adhesive layer is left on the semiconductor substrate. In addition, according to the present invention, it is possible to provide a releasability-imparting agent capable of exhibiting sufficient adhesion and a release and removal effect when a small amount thereof is added. According to the present invention, it is possible to provide a laminate having an adhesive layer formed from the adhesive composition, a method for producing a semiconductor substrate using the laminate, and a method for producing the laminate.

### Brief Description of Drawings

Fig. 1A is a schematic cross-sectional view of an example of a laminate.
Fig. 1B is a schematic cross-sectional view of another example of a laminate.
Fig. 2A is a view (part 1) for illustrating an aspect of producing a laminate and producing a thinned wafer.
Fig. 2B is a view (part 2) for illustrating an aspect of producing a laminate and producing a thinned wafer.
Fig. 2C is a view (part 3) for illustrating an aspect of producing a laminate and producing a thinned wafer.
Fig. 2D is a view (part 4) for illustrating an aspect of producing a laminate and producing a thinned wafer.
Fig. 2E is a view (part 5) for illustrating an aspect of producing a laminate and producing a thinned wafer.
Fig. 2F is a view (part 6) for illustrating an aspect of producing a laminate and producing a thinned wafer.

### Description of Embodiments

### (Adhesive composition)

The adhesive composition of the present invention contains a polymer (P).

The adhesive composition of the present invention can be suitably used to form an adhesive layer for temporary adhesion to process a semiconductor substrate.

### <Polymer (P)>

The polymer (P) has an amide bond (-CONH-) and a polyorganosiloxane structure.

When the adhesive composition contains the polymer (P), the adhesive layer obtained from the adhesive composition is released from the adherend in a short time by an organic solvent. Therefore, when more adhesive layer is left on the semiconductor substrate, the adhesive layer can be released and removed in a short time.

The polymer (P) is a releasability-imparting agent used in the adhesive composition. The polymer (P) used as the releasability-imparting agent can exhibit sufficient adhesion and a release and removal effect when added in a small amount.

The polymer (P) as the releasability-imparting agent used in the adhesive composition is also an object of the present invention.

The polymer (P) preferably has an amide bond in a main chain.

The polymer (P) preferably has a polyorganosiloxane structure in a main chain.

The polyorganosiloxane structure is preferably a linear structure.

The polyorganosiloxane structure is preferably a structure represented by a formula (1) below: 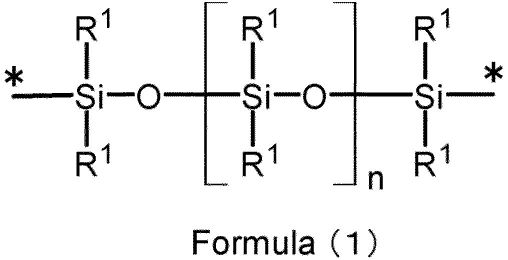 wherein, in the formula (1), R¹ each independently represents an alkyl group having 1 to 4 carbon atoms or a phenyl group, n represents a repeating unit number and is a positive integer, and * represents a bonding hand.

n is, for example, 1 to 500, preferably 5 to 400, and more preferably 10 to 300.

Examples of the alkyl group having 1 to 4 carbon atoms in R¹ include a methyl group, an ethyl group, a n-propyl group, and a n-butyl group. Among them, a methyl group is preferable.

The polymer (P) can be obtained, for example, by the following methods (i) to (iv).
(i) Method for obtaining the polymer by reacting a polyorganosiloxane having an amino group with a compound having a carboxy group between the amino group and the carboxy group
(ii) Method for obtaining the polymer by reacting a polyorganosiloxane having a carboxy group with a compound having an amino group between the carboxy group and the amino group
(iii) Method for obtaining the polymer by reacting a polyorganosiloxane having an amino group with a polyorganosiloxane having a carboxy group between the amino group and the carboxy group
(iv) Method for obtaining the polymer by polymerizing a radically polymerizable monomer using a polymer initiator (I) having a polyorganosiloxane structure, an amide bond, and an azo group

The polyorganosiloxane having an amino group is also referred to as amino-modified silicone oil or amino-modified silicone.

The polyorganosiloxane having an amino group has, for example, a structure in which a part of the hydrocarbon groups on the side chain and/or the terminal of the polyorganosiloxane is substituted with a modifying group having an amino group such as -R-NH₂ or -RNHR'NH₂ (In the formulae, R and R' each independently represent a hydrocarbon group.).

The polyorganosiloxane having an amino group is usually linear.

The position of the amino group in the polyorganosiloxane having an amino group is not particularly limited, and examples thereof include a side chain, one terminal, and both terminals. Among them, one terminal or both terminals are preferable.

As the polyorganosiloxane having an amino group, a polyorganosiloxane represented by the following formula (1-1) is preferable: 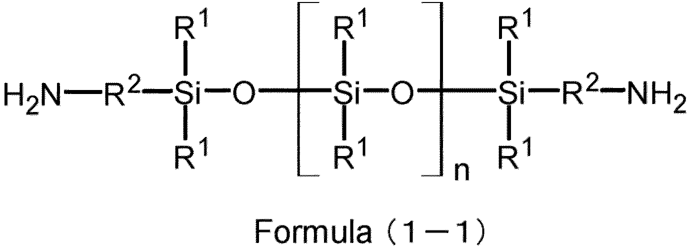 wherein, in the formula (1-1), R¹ each independently represents an alkyl group having 1 to 4 carbon atoms or a phenyl group, R² each independently represents an alkylene group having 1 to 5 carbon atoms, and n represents a repeating unit number and is a positive integer.

n is, for example, 1 to 500, preferably 5 to 400, and more preferably 10 to 300.

As the polyorganosiloxane having an amino group, a commercially available product may be used. Examples of the commercially available products include: PAM-E, KF-8010, X-22-161A, X-22-161B, KF-8012, KF-8008, X-22-1660B-3, X-22-9409, KF-868, KF-865, KF-864, KF-859, KF-393, KF-860, KF-880, KF-8004, KF-8002, KF-8005, KF-867, KF-8021, KF-869, KF-861, and the like, each of which is manufactured by Shin-Etsu Chemical Co., Ltd.; FZ-3508, BY16-205, FZ-3705, BY16-850, FZ-3501, FZ-3785, BY16-213, BY16-203, BY16-849, BY16-890, BY16-893, SS-3588, SF8451C, SF8452C, SF8457C, and the like, each of which is manufactured by DuPont Toray Specialty Materials K.K.; WACKER FINISH WR series, each of which is manufactured by Wacker Asahikasei Silicone Co.,Ltd.; and TSF4700, TSF4701, TSF4702, TSF4703, TSF4704, TSF4705, TSF4706, TSF4707, TSF4708, TSF4709, and the like, each of which is manufactured by Momentive Performance Materials Inc. Among them, KF-8012, KF-8008, X-22-161A, and the like are preferable.

The compound having a carboxy group is not particularly limited as long as it has a carboxy group, and examples thereof include a compound having one carboxy group and a compound having two carboxy groups.

The molecular weight of the compound having a carboxy group is not particularly limited, and is preferably 60 to 500, more preferably 60 to 400, and particularly preferably 60 to 300. Examples of the compound having a carboxy group include acetic acid, succinic acid, adipic acid, sebacic acid, heptanoic acid, octanoic acid, α-phenylcinnamic acid, and 2-naphthalenecarboxylic acid.

In the reaction (i) above, an acid halide of the compound or an esterified product of the compound may be used instead of the compound having a carboxy group. For example, adipic acid dichloride may be used instead of adipic acid.

The polyorganosiloxane having a carboxy group is also referred to as carboxy-modified silicone oil or carboxy-modified silicone.

The polyorganosiloxane having a carboxy group has, for example, a structure in which a part of the hydrocarbon groups on the side chain and/or the terminal of the polyorganosiloxane is substituted with a modifying group having a carboxy group such as -R-COOH (In the formula, R represents a hydrocarbon group.).

The polyorganosiloxane having a carboxy group is usually linear.

The position of the carboxy group in the polyorganosiloxane having a carboxy group is not particularly limited, and examples thereof include a side chain, one terminal, and both terminals. Among them, one terminal or both terminals are preferable.

The polyorganosiloxane having a carboxy group may be a commercially available product. Examples of the commercially available products include X-22-162C and X-22-3701E, which are manufactured by Shin-Etsu Chemical Co., Ltd., and BY-16-880 and BY 16-750 Fluid, which are manufactured by DuPont Toray Specialty Materials K.K.

The compound having an amino group is not particularly limited as long as it has an amino group (-NH₂), and examples thereof include a compound having one amino group and a compound having two amino groups.

The molecular weight of the compound having an amino group is not particularly limited, and is preferably 45 to 500, more preferably 45 to 400, and particularly preferably 45 to 300.

The compound having an amino group may be the above-mentioned polyorganosiloxane having an amino group.

Examples of the polymer initiator (I) having a polyorganosiloxane structure, an amide bond, and an azo group include an initiator represented by the following formula (Ia): 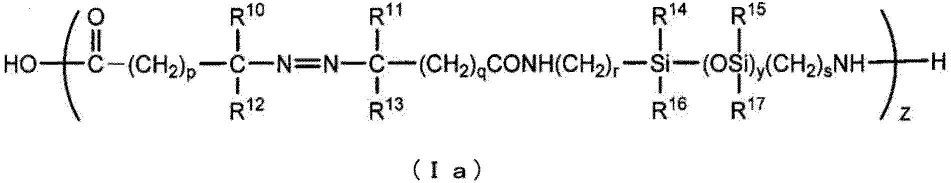 wherein, in the formula (Ia), R¹⁰ to R¹³ each independently represent a hydrogen atom, an alkyl group, or a cyano group, R¹⁴ to R¹⁷ each independently represent a hydrogen atom or an alkyl group, p and q each independently represent an integer of 1 to 6, r and s each independently represent an integer of 0 to 6, y represents an integer of 1 to 300, and z represents an integer of 1 to 20.

Examples of the initiator represented by the formula (Ia) include an initiator represented by the following formula (Ia-1): 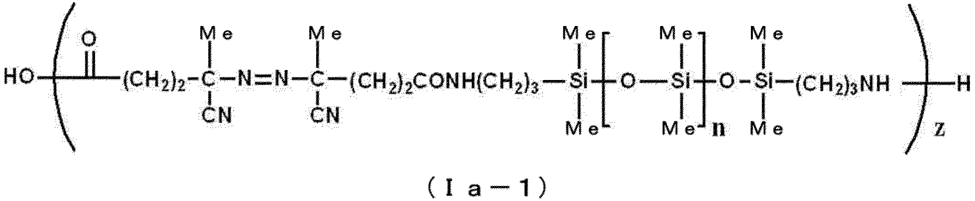 wherein, in the formula (Ia-1), Me represents a methyl group, n represents an integer of 1 to 300, and z represents an integer of 1 to 20.

Examples of the commercially available products of the polymer initiator (I) include VPS-1001N (manufactured by FUJIFILM Wako Pure Chemical Corporation).

Examples of the radically polymerizable monomer include acrylic compounds, methacrylic compounds, or compounds having a vinyl group, such as methyl methacrylate, ethyl methacrylate, isopropyl methacrylate, cyclohexyl methacrylate, 2,2,2-trifluoroethyl methacrylate, 2-hydroxypropyl methacrylate, γ-butyrolactone methacrylate, benzyl methacrylate, p-t-butoxystyrene, p-acetoxystyrene, p-ethoxyethyl styrene, styrene, anthracene methyl methacrylate, phenyl methacrylate, p-hydroxyphenyl methacrylate, naphthyl methacrylate, adamantyl methacrylate, hydroxyadamantyl methacrylate, norbornene lactone methacrylate, ethyl adamantyl methacrylate, methyl acrylate, ethyl acrylate, isopropyl acrylate, cyclohexyl acrylate, 2,2,2-trifluoroethyl acrylate, 2-hydroxypropyl acrylate, γ-butyrolactone acrylate, benzyl acrylate, anthracene methyl acrylate, phenyl acrylate, p-hydroxyphenyl acrylate, naphthyl acrylate, vinyl naphthalene, acenaphthylene, 4-allyloxy-2-hydroxybenzophenone, 2-[2-hydroxy-5-[2-(methacryloyloxy)ethyl]phenyl]-2H-benzotriazole, vinyl acetate, and vinyl benzoate.

These can be used singly or in combination of two or more kinds thereof.

The ratio between the amide bond and the polyorganosiloxane structure in the polymer (P) is not particularly limited, but it is preferable that the polymer (P) has one to three amide bonds on average for one polyorganosiloxane structure.

The polymer (P) does not have, for example, a group that causes a hydrosilylation reaction. Examples of the group that causes a hydrosilylation reaction include an alkenyl group and an Si-H group. Examples of the alkenyl group include an alkenyl group having 2 to 40 carbon atoms and bonded to a silicon atom.

The molecular weight of the polymer (P) is not particularly limited, but the weight average molecular weight (Mw) of the polymer (P) in terms of polystyrene measured by gel permeation chromatography (GPC) is preferably 3,000 to 200,000, more preferably 5,000 to 150,000, and particularly preferably 10,000 to 80,000.

The dispersity (weight average molecular weight (Mw)/number average molecular weight (Mn)) of the polymer (P) is not particularly limited, but is preferably 1.0 to 20.0, and more preferably 1.2 to 10.0.

The content of the polymer (P) in the adhesive composition is not particularly limited, but is preferably 0.1 to 15 mass%, more preferably 0.5 to 10 mass%, and particularly preferably 1.0 to 5.0 mass% with respect to the film constituent components in the adhesive composition from the viewpoint of reproducibly realizing the effect of the present invention.

In the present invention, the term "film constituent components" means components other than a solvent contained in the composition.

### <Adhesive component (S)>

The adhesive composition of the present invention preferably contains an adhesive component (S).

The adhesive component (S) is not particularly limited as long as it is used for this type of application, and examples thereof include siloxane-based adhesives, acrylic resin-based adhesives, epoxy resin-based adhesives, polyamide-based adhesives, polystyrene-based adhesives, polyimide adhesives, and phenol resin-based adhesives.

Among them, the adhesive component (S) is preferably a siloxane-based adhesive, which exhibits suitable adhesive ability during processing of a wafer or the like, can be suitably released after processing, and is excellent in heat resistance.

In a preferred embodiment, the adhesive composition of the present invention contains a component (A) that is cured by hydrosilylation reaction as the adhesive component (S) .

The component (A) may be a component that is cured by hydrosilylation reaction, or may be a polyorganosiloxane component (A') that is cured by hydrosilylation reaction.

In another preferred embodiment, the component (A) includes, for example: a polyorganosiloxane (a1) having an alkenyl group bonded to a silicon atom and having 2 to 40 carbon atoms; a polyorganosiloxane (a2) having an Si-H group; and a platinum group metal-based catalyst (A2), as an example of the component (A'). Here, the alkenyl group having 2 to 40 carbon atoms may be substituted. Examples of the substituent include a halogen atom, a nitro group, a cyano group, an amino group, a hydroxy group, a carboxyl group, an aryl group, and a heteroaryl group.

In another preferred embodiment, the polyorganosiloxane component (A') that is cured by hydrosilylation reaction includes a polysiloxane (A1) containing one or two or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}, and a platinum group metal-based catalyst (A2). The polysiloxane (A1) includes: a polyorganosiloxane (a1') containing one or two or more units selected from the group consisting of a siloxane unit (Q' unit) represented by SiO₂, a siloxane unit (M' unit) represented by R¹'R²'R³'SiO_{1/2}, a siloxane unit (D' unit) represented by R⁴'R⁵'S1O_{2/2}, and a siloxane unit (T' unit) represented by R⁶'SiO_{3/2}, and also containing at least one selected from the group consisting of the M' unit, the D' unit, and the T' unit; and a polyorganosiloxane (a2') containing one or two or more units selected from the group consisting of a siloxane unit (Q" unit) represented by SiO₂, a siloxane unit (M" unit) represented by R¹"R²"R³"SiO_{1/2}, a siloxane unit (D" unit) represented by R⁴"R⁵"SiO_{2/2}, and a siloxane unit (T" unit) represented by R⁶"SiO_{3/2}, and also containing at least one selected from the group consisting of the M" unit, the D" unit, and the T" unit.

Note that (a1') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹' to R⁶' are groups bonded to a silicon atom and each independently represent an optionally substituted alkyl group or an optionally substituted alkenyl group, and at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹" to R⁶" are groups or atoms bonded to a silicon atom and each independently represent an optionally substituted alkyl group or a hydrogen atom, and at least one of R¹" to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, and is preferably a linear or branched alkyl group. The number of carbon atoms thereof is not particularly limited, and is usually 1 to 40, preferably 30 or less, more preferably 20 or less, and still more preferably 10 or less.

Specific examples of the linear or branched and optionally substituted alkyl group include a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto. The number of carbon atoms thereof is usually 1 to 14, preferably 1 to 10, and more preferably 1 to 6. Among them, a methyl group is particularly preferable.

Specific examples of the cyclic and optionally substituted alkyl group include: cycloalkyl groups, such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and bicycloalkyl groups, such as a bicyclobutyl group, a bicyclopentyl group, a bicyclohexyl group, a bicycloheptyl group, a bicyclooctyl group, a bicyclononyl group, and a bicyclodecyl group, but are not limited thereto. The number of carbon atoms thereof is usually 3 to 14, preferably 4 to 10, and more preferably 5 to 6.

The alkenyl group may be linear or branched, and the number of carbon atoms thereof is not particularly limited, and is usually 2 to 40, and is preferably 30 or less, more preferably 20 or less, and still more preferably 10 or less.

Specific examples of the linear or branched and optionally substituted alkenyl group include a vinyl group, an allyl group, a butenyl group, and a pentenyl group, and are not limited thereto. The number of carbon atoms thereof is usually 2 to 14, preferably 2 to 10, and more preferably 1 to 6. Among them, an ethenyl group and a 2-propenyl group are particularly preferable.

Specific examples of the cyclic and optionally substituted alkenyl group include, but are not limited to, cyclopentenyl and cyclohexenyl. The number of carbon atoms thereof is usually 4 to 14, preferably 5 to 10, and more preferably 5 to 6.

As described above, the polysiloxane (A1) contains the polyorganosiloxane (a1') and the polyorganosiloxane (a2'), and an alkenyl group contained in the polyorganosiloxane (a1') and a hydrogen atom (Si-H group) contained in the polyorganosiloxane (a2') form a crosslinked structure through hydrosilylation reaction by the platinum group metal-based catalyst (A2) to be cured. As a result, a cured film is formed.

The polyorganosiloxane (a1') contains one or two or more units selected from the group consisting of the Q' unit, the M' unit, the D' unit, and the T' unit, and also contains at least one selected from the group consisting of the M' unit, the D' unit, and the T' unit. As the polyorganosiloxane (a1'), two or more polyorganosiloxanes satisfying such conditions may be used in combination.

Preferred combinations of two or more selected from the group consisting of the Q' unit, the M' unit, the D' unit, and the T' unit include, but are not limited to, (the Q' unit and the M' unit), (the D' unit and the M' unit), (the T' unit and the M' unit), and (the Q' unit, the T' unit, and the M' unit).

When the polyorganosiloxane (a1') contains two or more polyorganosiloxanes, a combination of (the Q' unit and the M' unit) and (the D' unit and the M' unit), a combination of (the T' unit and the M' unit) and (the D' unit and the M' unit), and a combination of (the Q' unit, the T' unit, and the M' unit) and (the T' unit and the M' unit) are preferable, but the combination is not limited thereto.

The polyorganosiloxane (a2') contains one or two or more units selected from the group consisting of the Q" unit, the M" unit, the D" unit, and the T" unit, and also contains at least one selected from the group consisting of the M" unit, the D" unit, and the T" unit. As the polyorganosiloxane (a2'), two or more polyorganosiloxanes satisfying such conditions may be used in combination.

Preferred combinations of two or more selected from the group consisting of the Q" unit, the M" unit, the D" unit, and the T" unit include, but are not limited to, (the M" unit and the D" unit), (the Q" unit and the M" unit), and (the Q" unit, the T" unit, and the M" unit).

The polyorganosiloxane (a1') is composed of siloxane units in which alkyl groups and/or alkenyl groups are bonded to silicon atoms thereof, and the proportion of alkenyl groups in the total substituents represented by R¹' to R⁶' is preferably 0.1 to 50.0 mol% and more preferably 0.5 to 30.0 mol%, and the remaining R¹' to R⁶' may be alkyl groups.

The polyorganosiloxane (a2') is composed of siloxane units in which alkyl groups and/or hydrogen atoms are bonded to silicon atoms thereof, and the proportion of hydrogen atoms in the total substituent groups and substituent atoms represented by R¹" to R⁶" is preferably 0.1 to 50.0 mol% and more preferably 10.0 to 40.0 mol%, and the remaining R¹" to R⁶" may be alkyl groups.

When the component (A) contains (a1) and (a2), in a preferred embodiment of the present invention, the molar ratio of the alkenyl group contained in the polyorganosiloxane (a1) and the hydrogen atom constituting the Si-H bond contained in the polyorganosiloxane (a2) is in a range of 1.0 : 0.5 to 1.0 : 0.66.

The weight average molecular weight of the polysiloxanes such as the polyorganosiloxane (a1) and the polyorganosiloxane (a2) is not particularly limited, and is usually 500 to 1,000,000, and is preferably 5,000 to 50,000 from the viewpoint of reproducibly realizing the effects of the present invention.

In the present invention, the weight average molecular weight, the number average molecular weight, and the dispersity of the polyorganosiloxanes can be measured, for example, using a GPC apparatus (EcoSEC, HLC-8320GPC; manufactured by Tosoh Corporation) and a GPC column (TSKgel SuperMultipore HZ-N and TSKgel SuperMultipore HZ-H; manufactured by Tosoh Corporation), at a column temperature of 40°C, using tetrahydrofuran as an eluent (elution solvent), at a flow amount (flow rate) of 0.35 mL/min, and using polystyrene (Shodex from Showa Denko K.K.) as a standard sample.

The viscosity of each of the polyorganosiloxane (a1) and the polyorganosiloxane (a2) is not particularly limited, but is usually 10 to 1,000,000 (mPa·s), and is preferably 50 to 20,000 (mPa·s) from the viewpoint of reproducibly realizing the effects of the present invention. The viscosity of each of the polyorganosiloxane (a1) and the polyorganosiloxane (a2) is a value measured with an E-type rotational viscometer at 25°C.

The polyorganosiloxane (a1) and the polyorganosiloxane (a2) react with each other through hydrosilylation reaction to form a film. Therefore, the curing mechanism is different from that via, for example, silanol groups. Therefore, either siloxane does not need to contain a silanol group or a functional group that forms a silanol group through hydrolysis, such as an alkyloxy group.

In a preferred embodiment of the present invention, the adhesive composition contains a platinum group metal-based catalyst (A2) together with the polyorganosiloxane component (A').

Such a platinum-based metal catalyst is a catalyst to promote hydrosilylation reaction between the alkenyl group of the polyorganosiloxane (a1) and the Si-H group of the polyorganosiloxane (a2).

Specific examples of the platinum-based metal catalyst include platinum-based catalysts such as platinum black, platinum (II) chloride, chloroplatinic acid, a reaction product of chloroplatinic acid and a monohydric alcohol, a complex of chloroplatinic acid and olefins, and platinum bisacetoacetate, but are not limited thereto.

Examples of the complex of platinum and olefins include, but are not limited to, a complex of divinyltetramethyldisiloxane and platinum.

The amount of the platinum group metal-based catalyst (A2) is not particularly limited, but is usually in a range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of hydrosilylation reaction.

The polymerization inhibitor is not particularly limited as long as it can suppress the progress of hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, and is usually 1000.0 ppm or more with respect to the total amount of the polyorganosiloxane (a1) and the polyorganosiloxane (a2) from the viewpoint of obtaining the effect, and is 10000.0 ppm or less from the viewpoint of preventing excessive suppression of hydrosilylation reaction.

The adhesive composition preferably contains the polymer (P) and the curable component (A).

On the other hand, the adhesive composition optionally contains a release agent component other than the polymer (P). Examples of the release agent component other than the polymer (P) include a polyorganosiloxane that causes no curing reaction.

The term "causes no curing reaction" does not mean not causing any curing reactions, but means not causing a curing reaction occurring in the component (A), which is curable.

The adhesive composition, as an example, can contain the polymer (P) and the curable component (A) in any ratio. In consideration of the balance of removal and adhesion, the ratio of the polymer (P) to the curable component (A) is, in terms of mass ratio [(P) : (A)], preferably 0.005 : 99.995 to 70 : 30, and more preferably 0.1 : 99.9 to 25 : 75.

That is, when the polyorganosiloxane component (A'), which is cured through hydrosilylation reaction, is contained, the ratio of the polymer (P) to the component (A') is, in terms of mass ratio [(P) : (A')], preferably 0.005 : 99.995 to 70 : 30, and more preferably 0.1 : 99.9 to 25 : 75.

### <Solvent>

The adhesive composition may contain a solvent for the purpose of adjusting the viscosity. Specific examples thereof include aliphatic hydrocarbons, aromatic hydrocarbons, and ketones, but are not limited thereto.

More specific examples of the solvent include hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone, but are not limited thereto. Such solvents can be used singly or in combination of two or more kinds thereof.

When the adhesive composition contains a solvent, the content thereof is appropriately determined in consideration of the desired viscosity of the composition, the coating method to be employed, the thickness of the film to be produced, and the like, and is in a range of about 10 to 90 mass% with respect to the entire composition.

The viscosity of the adhesive composition is not particularly limited, but is usually 500 to 20,000 mPa·s, and preferably 1,000 to 5,000 mPa·s at 25°C. The viscosity of the adhesive composition used in the present invention can be adjusted by changing the type of solvent to be used, the ratio thereof, the concentration of the film constituent components, and the like, in consideration of various factors such as the coating method to be used and the desired film thickness.

### (Laminate)

The laminate of the present invention includes a semiconductor substrate, a support substrate, and an adhesive layer.

The adhesive layer is interposed between the semiconductor substrate and the support substrate and in contact with the semiconductor substrate.

The adhesive layer is formed from the adhesive composition of the present invention described above.

The laminate is used for temporary adhesion to process a semiconductor substrate, and can be suitably used for applications in which the support substrate and the semiconductor substrate are separated after processing the semiconductor substrate in the laminate.

In the laminate of the present invention, the number of the adhesive layer is not particularly limited, and is appropriately selected according to the purpose. For example, in the laminate, the adhesive layer may be one layer or two or more layers.

In addition, the laminate of the present invention may include a layer other than the adhesive layer between the semiconductor substrate and the support substrate, and examples thereof include a laminate including an adhesive layer and a release layer between the semiconductor substrate and the support substrate.

One preferred aspect of the laminate of the present invention is a laminate including a semiconductor substrate, an adhesive layer, a release layer, and a support substrate in this order.

Hereinafter, an example of the laminate is described with reference to the drawings.

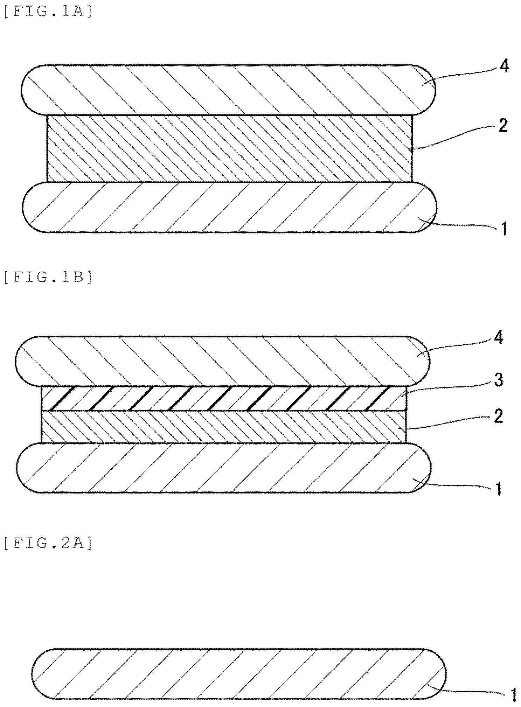

Fig. 1A is a schematic cross-sectional view of an example of a laminate.

The laminate of Fig. 1A includes a semiconductor substrate 1, an adhesive layer 2, and a support substrate 4 in this order.

The adhesive layer 2 is provided between the semiconductor substrate 1 and the support substrate 4. The adhesive layer 2 is in contact with the semiconductor substrate 1.

Fig. 1B is a schematic cross-sectional view of another example of a laminate.

The laminate of Fig. 1B includes a semiconductor substrate 1, an adhesive layer 2, a release layer 3, and a support substrate 4 in this order.

The adhesive layer 2 is provided between the semiconductor substrate 1 and the support substrate 4. The adhesive layer 2 is in contact with the semiconductor substrate 1.

The release layer 3 is provided between the adhesive layer 2 and the support substrate 4. The release layer 3 is in contact with the adhesive layer 2 and the support substrate 4.

Each configuration of the laminate of the present invention will be described in detail below.

### <Semiconductor substrate>

The semiconductor substrate has, for example, a bump. The bump is a protruding terminal.

In the laminate, the semiconductor substrate has a bump on the support substrate side.

In the semiconductor substrate, the bump is usually formed on a surface on which a circuit is formed. The circuit may be a single layer or a multilayer. The shape of the circuit is not particularly limited.

In the semiconductor substrate, the surface opposite to the surface in contact with the adhesive layer (back surface) is a surface to be processed.

The main material constituting the entire semiconductor substrate is not particularly limited as long as it is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface. For example, the outer periphery of the semiconductor substrate may have a straight portion called an orientation flat or may have a cut called a notch.

The thickness of the disk-shaped semiconductor substrate may be appropriately determined according to the purpose of use of the semiconductor substrate and the like, and is not particularly limited, and is, for example, 500 to 1,000 um.

The diameter of the disk-shaped semiconductor substrate may be appropriately determined according to the purpose of use of the semiconductor substrate and the like, and is not particularly limited, and is, for example, 100 to 1,000 mm.

An example of the semiconductor substrate is a silicon wafer having a diameter of about 300 mm and a thickness of about 770 um.

The material, size, shape, structure, and density of the bump the semiconductor substrate has are not particularly limited.

Examples of the bump include a ball bump, a printed bump, a stud bump, and a plated bump.

Usually, the height, diameter, and pitch of the bump are appropriately determined from the conditions of a bump height of about 1 to 200 µm, a bump diameter of 1 to 200 um, and a bump pitch of 1 to 500 um.

Examples of the material of the bump include low-melting-point solder, high-melting-point solder, tin, indium, gold, silver, and copper. The bump may be composed only of a single component or may be composed of a plurality of components. More specific examples thereof include an alloy plating mainly containing Sn, such as SnAg bumps, SnBi bumps, Sn bumps, and AuSn bumps.

In addition, the bump may have a layered structure having a metal layer composed of at least one of these components.

### <Support substrate>

The support substrate is not particularly limited as long as it is a member capable of supporting the semiconductor substrate when the semiconductor substrate is processed. Examples thereof include a glass support substrate and a silicon support substrate.

The shape of the support substrate is not particularly limited, and examples thereof include a disk shape. Note that the disk-shaped support substrate does not need to have a complete circular surface. For example, the outer periphery of the support substrate may have a straight portion called an orientation flat or may have a cut called a notch.

The thickness of the disk-shaped support substrate may be appropriately determined according to the size of the semiconductor substrate and the like, and is not particularly limited, and is, for example, 500 to 1,000 um.

The diameter of the disk-shaped support substrate may be appropriately determined according to the size of the semiconductor substrate and the like, and is not particularly limited, and is, for example, 100 to 1,000 mm.

An example of the support substrate is a glass wafer or a silicon wafer having a diameter of about 300 mm and a thickness of about 700 µm.

When the laminate includes a release layer and the release layer is irradiated with light for release from the support substrate side, the support substrate that transmits light is used. The light transmittance in this case is usually 50% or more, preferably 80% or more, and more preferably 90% or more. Specific examples thereof include, but are not limited to, a glass support substrate.

### <Adhesive layer>

The adhesive layer is provided between the support substrate and the semiconductor substrate.

The adhesive layer is in contact with the semiconductor substrate.

The adhesive layer is formed using the adhesive composition of the present invention described above, and more specifically, is formed by curing the adhesive composition.

The thickness of the adhesive layer is not particularly limited, but is preferably 20 to 120 µm, and more preferably 40 to 100 um.

The method for forming the adhesive layer from the adhesive composition is described in detail in the description of <Method for producing laminate> described below.

### <Release layer>

The laminate of the present invention may include a release layer.

When the laminate has a release layer, for example, the release layer can be disposed so that the release layer is in contact with the support substrate and the adhesive layer.

The type of the release layer and the release method are not particularly limited as long as the release layer contributes to improvement of the releasability by heating or light irradiation and can separate the semiconductor substrate and the support substrate in the laminate, but for example, the release layer described below can be used.

The release layer is a film obtained from a release agent composition containing an organic resin and a solvent. In an embodiment, the film is a cured film obtained by curing the film constituent components in the release agent composition.

The release agent composition may further contain a crosslinking agent, an acid catalyst, and a surfactant.

The release agent composition contains an organic resin. The organic resin is preferably one that can exhibit a suitable releasing ability. When the semiconductor substrate and the support substrate are separated by light-irradiating the release layer, the organic resin absorbs light and suitably undergoes a deterioration that is necessary to improve releasing ability, for example, decomposition.

A preferred example of the organic resin includes a novolac resin.

When the release layer included in the laminate of the present invention is released by light-irradiation, a novolac resin that absorbs light having a wavelength of 190 nm to 600 nm and is altered is preferable, and a novolac resin that is altered by irradiation with light such as a laser having a wavelength of 308 nm, 343 nm, 355 nm, or 365 nm is more preferable.

As a specific example, the novolac resin is a polymer containing one kind or two or more kinds selected from the group consisting of a unit represented by the following formula (C1-1), a unit represented by the following formula (C1-2), and a unit represented by the following formula (C1-3).

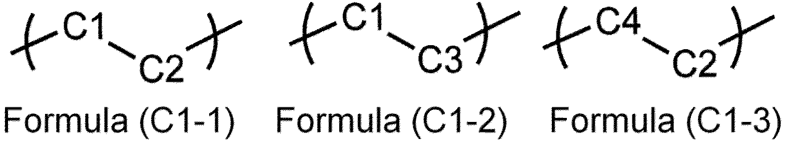

C1 represents a group derived from an aromatic compound containing a nitrogen atom. C2 represents a group containing a tertiary carbon atom having at least one selected from the group consisting of a secondary carbon atom, a quaternary carbon atom, and an aromatic ring in its side chain. C3 represents a group derived from an aliphatic polycyclic compound. C4 represents a group derived from phenol, a group derived from bisphenol, a group derived from naphthol, a group derived from biphenyl, or a group derived from biphenol.

For the novolac resin to be contained in the release agent composition and the release layer using the novolac resin, the novolac resin described in WO 2019/088103 and the release layer using the novolac resin may be taken into consideration.

The release layer is formed by applying, drying, and curing the release agent composition.

The thickness of the release layer included in the laminate is appropriately determined in consideration of the degree of releasability and the like, and is usually 5 to 10,000 nm, and is preferably 10 nnm or more, more preferably 50 nm or more, and still more preferably 100 nm or more from the viewpoint of suppressing deterioration of releasing performance due to being a thin film, reproducibly obtaining a release layer excellent in releasability, and the like, and is preferably 5,000 nm or less, more preferably 1,000 nm or less, and still more preferably 500 nm or less from the viewpoint of avoiding non-uniformity due to being a thick film, and the like.

### <Method for producing laminate>

When the adhesive layer in the laminate is composed of only a single adhesive layer formed using the adhesive composition of the present invention, the method for producing the laminate of the present invention includes a step of forming an adhesive layer (a step of forming an adhesive coating layer and a step of forming an adhesive layer), and further includes other steps such as a bonding step as necessary. The method for producing a laminate in this case will be described in detail in the following section <<First embodiment>>.

When the laminate includes an adhesive layer and a release layer, the method for producing the laminate of the present invention includes a step of forming a release layer in addition to a step of forming an adhesive layer (a step of forming an adhesive coating layer and a step of forming an adhesive layer), and further includes other steps such as a bonding step as necessary. The method for producing a laminate in this case will be described in detail in the following section <<Second embodiment>>.

### <<First embodiment>>

The adhesive layer is formed through the step of forming an adhesive coating layer and the step of forming an adhesive layer.

### <<<Step of forming adhesive coating layer>>>

In the step of forming an adhesive coating layer, for example, the adhesive composition is applied to a semiconductor substrate to form an adhesive coating layer.

The application method is not particularly limited, and is usually a spin coating method. Incidentally, it is possible to employ a method of separately forming a coating film by a spin coating method or the like and attaching the sheet-like coating film as the adhesive coating layer.

The thickness of the adhesive coating layer is appropriately determined in consideration of the thickness of the adhesive layer in the laminate and the like.

For the reason that the adhesive composition contains a solvent or the like, the applied adhesive composition may be heated for the purpose of drying the coating film of the applied adhesive composition (pre-heat treatment).

The heating temperature of the applied adhesive composition varies depending on the type and amount of the adhesive component contained in the adhesive composition, whether or not a solvent is contained, the boiling point of the solvent used, the desired thickness of the adhesive layer, and the like, and thus cannot be generally specified. The heating temperature is usually 80 to 150°C, and the heating time is usually 30 seconds to 5 minutes.

The heating can be performed using a hot plate, an oven, or the like.

### <<<Step of forming adhesive layer>>>

In the step of forming an adhesive layer, the adhesive coating layer is heated and the adhesive composition is cured to form an adhesive layer.

The step of forming an adhesive layer is not particularly limited as long as the adhesive layer is formed by heating the adhesive coating layer in a state where the support substrate and the adhesive coating layer are in contact with each other and the adhesive coating layer and the semiconductor substrate are in contact with each other.

For example, a semiconductor substrate on which an adhesive coating layer is formed and a support substrate are used, and the two substrates (semiconductor substrate and support substrate) are arranged so as to sandwich the adhesive coating layer. Thus, the support substrate and the adhesive coating layer are in contact with each other, and the adhesive coating layer and the semiconductor substrate are in contact with each other. Then, heat treatment may be performed (post-heat treatment).

The temperature and time of the heating are not particularly limited as long as the temperature and time allow the adhesive coating layer to convert into an adhesive layer.

The heating temperature is preferably 120°C or higher, and more preferably 150°C or higher from the viewpoint of achieving a sufficient curing rate, and is preferably 250°C or lower from the viewpoint of preventing the deterioration of each layer (including the support substrate and the semiconductor substrate) constituting the laminate. The temperature is more preferably 180 to 200°C.

The heating time is preferably 1 minute or more, and more preferably 5 minutes or more from the viewpoint of realizing suitable joining of the layers (including the support substrate and the semiconductor substrate) constituting the laminate, and is preferably 180 minutes or less, and more preferably 120 minutes or less from the viewpoint of suppressing or avoiding adverse effects on the layers due to excessive heating. The time is more preferably 1 to 20 minutes from the viewpoint of efficiency in substrate treatment.

The heating can be performed using a hot plate, an oven, or the like.

### <<<Bonding step>>>

The bonding step is preferably performed between the step of forming an adhesive coating layer and the step of forming an adhesive layer in order to sufficiently bond the semiconductor substrate and the support substrate.

The bonding step is not particularly limited as long as a substrate and a layer can be bonded to each other and the substrate and the layer are not damaged. Typically, the bonding step is a step in which a load is applied in the thickness direction of the support substrate and the semiconductor substrate. More preferably, the bonding step is a step in which a load is applied in the thickness direction of the support substrate and the semiconductor substrate under reduced pressure.

The load is not particularly limited as long as a substrate and a layer can be bonded and the substrate and the layer are not damaged, and is, for example, 10 to 1,000 N.

The degree of pressure reduction is not particularly limited as long as a substrate and a layer can be bonded to each other and the substrate and the layer are not damaged, and is, for example, 10 to 10,000 Pa.

### <<Second embodiment>>

As a preferred aspect of the method for producing a laminate including a release layer, the method for producing a laminate will be described below by taking, as an example, the case of using a release layer formed from a release agent composition containing an organic resin such as the novolac resin described above.

An adhesive coating layer is formed on a semiconductor substrate by a method similar to the method described in the section of the step of forming an adhesive coating layer in << First embodiment >> described above.

The release agent composition is applied on a support substrate to form a release agent coating layer, and the release agent coating layer is heated and cured to form a release layer. Here, as the method for applying the release agent composition, the same method as the application method described in the section of the step of forming an adhesive coating layer in <<First embodiment>> can be used.

A semiconductor substrate on which the adhesive coating layer is formed and a support substrate on which the release layer is formed are used, and the two substrates (semiconductor substrate and support substrate) are arranged so as to sandwich the two layers (adhesive coating layer and release layer). Thus, the adhesive coating layer and the release layer are in contact with each other. Then, heat treatment may be performed.

The temperature and time of the heating are not particularly limited as long as the temperature and time allow the adhesive coating layer to convert into an adhesive layer.

As the heating conditions, the same conditions as those described in the step of forming an adhesive layer in <<First embodiment>> described above can be used.

### <<<Bonding step>>>

The bonding step is preferably performed between the step of forming an adhesive coating layer and the step of forming an adhesive layer in order to sufficiently bond the semiconductor substrate and the support substrate.

As the bonding step, the same conditions as those described in <<First embodiment>> described above can be used.

### (Method for producing semiconductor substrate)

The laminate of the present invention is used for temporary adhesion to process a semiconductor substrate, and can be suitably used for applications in which the support substrate and the semiconductor substrate are separated after processing the semiconductor substrate in the laminate.

The method for producing a semiconductor substrate of the present invention includes at least a processing step of processing the semiconductor substrate and a release step of separating the support substrate and the processed semiconductor substrate, and further includes other steps such as a removal step as necessary.

### <Processing step>

The processing step is not particularly limited as long as it is a step of processing the semiconductor substrate in the laminate of the present invention, and includes, for example, a polishing treatment, a through electrode-forming treatment, and the like.

### <<Polishing treatment>>

The polishing treatment is not particularly limited as long as it is, for example, a treatment of polishing the surface of the semiconductor substrate opposite to the surface in contact with the adhesive layer to thin the semiconductor substrate. Examples thereof include physical polishing using a polishing agent or a grindstone.

The polishing treatment can be performed using a general polishing apparatus used for polishing a semiconductor substrate.

By the polishing treatment, the thickness of the semiconductor substrate is reduced, and a semiconductor substrate thinned to a desired thickness is obtained. The thickness of the thinned semiconductor substrate is not particularly limited, and may be, for example, 30 to 300 µm or 30 to 100 µm.

### <<Through electrode-forming step>>

In the polished semiconductor substrate, a through electrode may be formed for realizing conduction between thinned semiconductor substrates when a plurality of thinned semiconductor substrates is laminated.

Therefore, the method for producing a semiconductor substrate may include a through electrode-forming treatment for forming a through electrode in the polished semiconductor substrate after the polishing treatment and before the release step.

The method for forming a through electrode in the semiconductor substrate is not particularly limited. Examples thereof include forming a through hole and filling the formed through hole with a conductive material.

The through hole is formed by, for example, photolithography.

The conductive material is filled into the through hole by, for example, a plating technique.

### <Release step>

The release step is not particularly limited as long as it is a step in which the support substrate and the processed semiconductor substrate are separated after the processing step.

Examples thereof include, but are not limited to, solvent releasing, releasing by light irradiation (laser light, non-laser light), mechanical releasing with equipment having a sharp part (so-called a debonder), and manual releasing between the support substrate and the semiconductor substrate. Usually, the releasing is performed after the laminate of the present invention is produced and subjected to a predetermined processing or the like.

In particular, when the laminate includes a release layer, and the release layer is formed using an organic resin that absorbs light and causes alteration necessary for improving the releasing ability as described above, the release layer can be released by, for example, irradiating laser from the support substrate side.

As the wavelength of the laser light, for example, ultraviolet light having a wavelength of 190 nm to 400 nm or 190 nm to 600 nm (for example, 308 nm, 355 nm, or 532 nm) is used and performed.

The releasing can be performed, for example, by setting the processing energy density of the pulse laser to about 50 to 500 mJ/cm².

When the laminate includes a release layer, releasing usually occurs inside the release layer or at the interface between the release layer and an adjacent substrate or layer (for example, the adhesive layer). The fact that releasing occurs inside the release layer means that the release layer is cleaved.

### <Other steps>

### <<Removal step>>

The removal step is not particularly limited as long as it is a step of removing the adhesive layer after the release step, but is preferably a method of floating and removing the adhesive layer from the adherend using a cleaning agent composition.

When a cleaning agent composition is used, for example, the semiconductor substrate bonded to the adhesive layer can be immersed in the cleaning agent composition or the cleaning agent composition can be sprayed.

The cleaning agent composition contains a solvent.

Examples of the solvent include an aliphatic hydrocarbon, a solvent represented by the following formula (L), a solvent represented by the following formula (T), and a solvent represented by the following formula (M).

The content of these solvents in the cleaning agent composition is not particularly limited, but is preferably 60 mass% or more, more preferably 80 mass% or more, and particularly preferably 95 mass% or more.

### <<<Aliphatic hydrocarbon>>>

Examples of the aliphatic hydrocarbon include aliphatic hydrocarbons having 6 to 12 carbon atoms. Examples of the aliphatic hydrocarbon include n-hexane, n-heptane, n-octane, n-nonane, n-decane, n-undecane, n-dodecane, isododecane, and menthane.

### <<<Solvent represented by formula (L)>>>

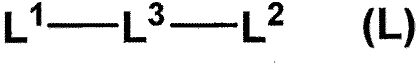

(In the formula (L), L¹ and L² each independently represent an alkyl group having 2 to 5 carbon atoms, and L³ represents O or S.)

L¹ and L² may be the same group or different groups, but are preferably the same group from the viewpoint of availability.

The alkyl group having 2 to 5 carbon atoms may be linear, branched, or cyclic, but is preferably a linear or branched alkyl group, and more preferably linear from the viewpoint of reproducibly realizing the releasing of the adhesive layer in a short time.

Specific examples of the linear or branched alkyl group include an ethyl group, a n-propyl group, an i-propyl group, a n-butyl group, an i-butyl group, an s-butyl group, a t-butyl group, and a n-pentyl group, but are not limited thereto.

Specific examples of the cyclic alkyl group include a cyclopropyl group, a cyclobutyl group, a 1-methyl-cyclopropyl group, a 2-methyl-cyclopropyl group, and a cyclopentyl group, but are not limited thereto.

From the viewpoint of reproducibly realizing the releasing of the adhesive layer in a short time, the alkyl group having 2 to 5 carbon atoms is preferably an ethyl group, a n-propyl group, a n-butyl group, or a n-pentyl group, and more preferably an ethyl group, a n-propyl group, or a n-butyl group.

From the viewpoint of reproducibly realizing the releasing of the adhesive layer in a shorter time, from the viewpoint of easy availability of the compound, and the like, L¹ and L² are preferably the same group.

Preferred examples of the organic solvent represented by the formula (L) include di(n-butyl) ether, diethyl ether, di(n-pentyl) ether, and di(n-propyl) sulfide from the viewpoint of reproducibly realizing the releasing of the adhesive layer in a shorter time and the viewpoint of easy availability of the compound.

### <<<Solvent represented by formula (T)>>>

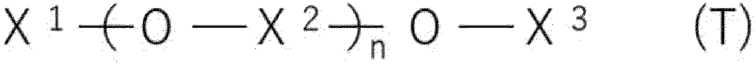

(In the formula (T), X¹ and X³ each independently represent a hydrogen atom, an alkyl group, or an acyl group (X⁴-C(=O)-), X² represents an alkylene group, n represents 2 or 3, and X⁴ represents a hydrogen atom or an alkyl group.)

Examples of the alkyl group represented by X₁ and X₃ include an alkyl group having 1 to 4 carbon atoms, and more specific examples thereof include a methyl group, an ethyl group, a propyl group, an isopropyl group, a n-butyl group, an isobutyl group, a sec-butyl group, and a t-butyl group.

Examples of the alkylene group represented by X₂ include a methylene group, a 1,2-ethylene group, a 1,3-propylene group, and a 1,2-propylene group.

Examples of the alkyl group represented by X₄ include an alkyl group having 1 to 4 carbon atoms, and examples thereof include the same alkyl groups as X₁ and X₃.

Preferred examples of the solvent represented by the formula (T) include dipropylene glycol dimethyl ether, diethylene glycol dimethyl ether, and diethylene glycol diethyl ether.

### <<<Solvent represented by formula (M)>>>

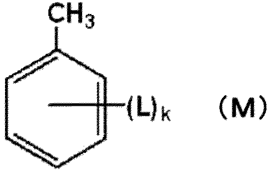

(In the formula (M), L represents a substituent substituting the benzene ring, each independently represents an alkyl group having 1 to 4 carbon atoms, and k represents the number of L and is an integer of 0 to 5.)

The alkyl group may be linear, branched, or cyclic, but is preferably a linear or branched alkyl group.

Specific examples of the linear or branched alkyl group include a methyl group, an ethyl group, a n-propyl group, an i-propyl group, a n-butyl group, an i-butyl group, a s-butyl group, and a t-butyl group, but are not limited thereto.

Specific examples of the cyclic alkyl group include a cyclopropyl group, a cyclobutyl group, a 1-methyl-cyclopropyl group, and a 2-methyl-cyclopropyl group, but are not limited thereto.

L is preferably a methyl group or an isopropyl group from the viewpoint of reproducibly realizing the releasing of the adhesive layer in a shorter time, the viewpoint of easy availability of the compound, and the like.

From the viewpoint of reproducibly realizing the releasing of the adhesive layer in a shorter time, from the viewpoint of easy availability of the compound, and the like, k is preferably 4 or less, more preferably 3 or less, and still more preferably 2 or less.

Preferred examples of the solvent represented by the formula (M) include toluene, mesitylene, p-cymene, and 1,2,4-trimethylbenzene from the viewpoint of reproducibly realizing the releasing of the adhesive layer in a shorter time and the viewpoint of easy availability of the compound.

An example of an aspect in which the laminate and the thinned wafer are produced in series will be described with reference to Figs. 2A to 2F.

Figs. 2A to 2F are views for illustrating an aspect of producing a laminate and producing a thinned wafer.

First, a wafer 1 is prepared (Fig. 2A).

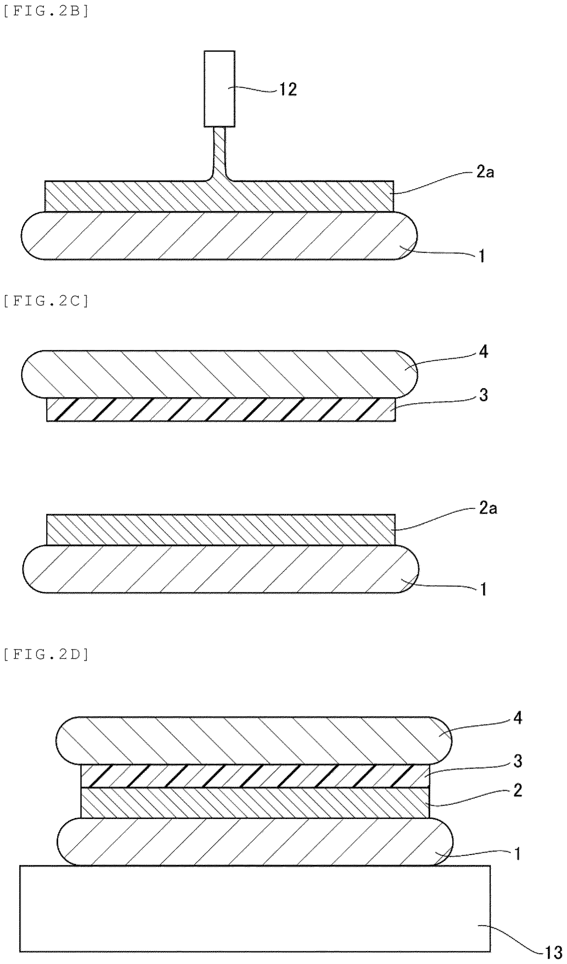

Next, the adhesive composition is applied onto the wafer 1 by spin coating using a coating device 12 to form an adhesive coating layer 2a (Fig. 2B).

Next, the release agent composition is applied onto a support substrate 4 by spin coating using a coating device (not illustrated), and the release agent composition is cured by heating to form a release layer 3, thereby preparing the support substrate 4 on which the release layer 3 is formed (Fig. 2C).

Next, the wafer 1 on which the adhesive coating layer 2a is formed and the support substrate 4 on which the release layer 3 is formed are bonded to each other under reduced pressure so as to sandwich the adhesive coating layer 2a and the release layer 3 therebetween, and then a heating device (hot plate) 13 is disposed on the surface of the wafer 1 opposite to the surface in contact with the adhesive coating layer 2a, and the adhesive coating layer 2a is heated by the heating device 13 to cure the adhesive composition and convert the adhesive composition into an adhesive layer 2 (Fig. 2D).

The laminate is obtained by the steps shown in Figs. 2A to 2D.

Next, an example of producing a thinned wafer will be described.

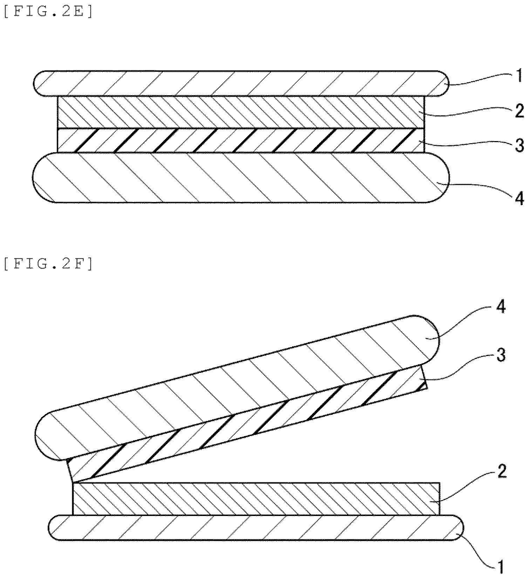

Next, the surface of the wafer 1 opposite to the surface in contact with the adhesive layer 2 is polished using a polishing apparatus (not illustrated) to thin the wafer 1 (Fig. 2E). A through electrode may be formed on the thinned wafer 1.

Next, the thinned wafer 1 and the support substrate 4 are released from each other by irradiating (not illustrated) light (ultraviolet light) from the support substrate 4 side (Fig. 2F). At this time, for example, the adhesive layer 2 and the release layer 3 are released from each other, whereby the thinned wafer 1 and the support substrate 4 are released from each other.

Next, using a cleaning device (not illustrated), the adhesive layer 2 is dissolved and removed from the thinned wafer 1 with a cleaning agent composition to clean the thinned wafer 1.

As described above, the thinned wafer 1 is obtained.

### Examples

Hereinafter, the present invention will be described more specifically with reference to Examples, but the present invention is not limited to the following Examples. The apparatuses used are as follows.

### [Apparatus]

(1) Stirrer A: ARE-500, a rotation and revolution mixer; manufactured by THINKY CORPORATION
(2) Viscometer: TVE-22H, a rotational viscometer; manufactured by Toki Sangyo Co.,Ltd.
(3) Optical film thickness meter (film thickness measurement): F-50; manufactured by Filmetrics, INC.
(4) Vacuum bonding apparatus: manual bonder; manufactured by SUSS MicroTec SE.
(5) Measurement of weight average molecular weight and dispersity: GPC apparatus (EcoSEC, HLC-8320GPC, which is manufactured by Tosoh Corporation) and GPC column (TSKgel SuperMultipore HZ-N, TSKgel SuperMultipore HZ-H from Tosoh Corporation)
   Column temperature: 40°C
   Eluent (elution solvent): tetrahydrofuran
   Flow amount (flow rate): 0.35 mL/min
   Standard sample: polystyrene (manufactured by Sigma-Aldrich Co. LLC)
(6) Laser irradiation device: Lambda SX; manufactured by Coherent Corp.

### [1] Synthesis of releasability-imparting agent

### [Preparation Example 1-1]

A flask was charged with 50.01 g of both-terminal amino-modified silicone KF8008 (manufactured by Shin-Etsu Chemical Co., Ltd.), 123.96 g of both-terminal carboxyl-modified silicone X-22-162C (manufactured by Shin-Etsu Chemical Co., Ltd.), and 267.92 g of THF (tetrahydrofuran) as a solvent, and the mixture was stirred at room temperature for about 5 minutes, then added with 3.33 g of diisopropylcarbodiimide, and stirred at room temperature for 20 hours. The reaction mixture was added dropwise to methanol and the product was reprecipitated. The obtained precipitate was separated by decantation, the precipitate was dissolved again in THF, and methanol and THF remaining were distilled off with an evaporator. A desired polymer having an amide group (releasability-imparting agent, Mw = 31055, Mw/Mn = 8.3) was obtained.

### [Preparation Example 1-2]

A flask was charged with 20.01 g of both-terminal amino-modified silicone KF8008 (manufactured by Shin-Etsu Chemical Co., Ltd.), 0.41 g of succinic acid, and 51.04 g of THF as a solvent, and the mixture was stirred at room temperature for about 5 minutes, then 1.34 g of diisopropylcarbodiimide was added, and the mixture was stirred at room temperature for 18 hours. The reaction mixture was separated with a 1 mass% aqueous solution of sodium hydroxide, and then the organic phase was added dropwise to methanol to reprecipitate the product. The obtained precipitate was separated by decantation, the precipitate was dissolved again in THF, and methanol and THF remaining were distilled off with an evaporator. A desired polymer having an amide group (releasability-imparting agent, Mw = 26979, Mw/Mn = 1.9) was obtained.

### [Preparation Example 1-3]

A flask was charged with 20.31 g of both-terminal amino-modified silicone KF8008 (manufactured by Shin-Etsu Chemical Co., Ltd.), 0.52 g of adipic acid, and 50.67 g of THF as a solvent, and the mixture was stirred at room temperature for about 5 minutes, then 1.36 g of diisopropylcarbodiimide was added, and the mixture was stirred at room temperature for 19 hours. The reaction mixture was separated with a 1 mass% aqueous solution of sodium hydroxide, and then the organic phase was added dropwise to methanol to reprecipitate the product. The obtained precipitate was separated by decantation, the precipitate was dissolved again in THF, and methanol and THF remaining were distilled off with an evaporator. A desired polymer having an amide group (releasability-imparting agent, Mw = 36129, Mw/Mn = 1.6) was obtained.

### [Preparation Example 1-4]

A flask was charged with 20.11 g of both-terminal amino-modified silicone KF8008 (manufactured by Shin-Etsu Chemical Co., Ltd.), 0.72 g of sebacic acid, and 51.14 g of THF as a solvent, and the mixture was stirred at room temperature for about 5 minutes, then 1.36 g of diisopropylcarbodiimide was added, and the mixture was stirred at room temperature for 23 hours. The reaction mixture was separated with a 1 mass% aqueous solution of sodium hydroxide, and then the organic phase was added dropwise to methanol to reprecipitate the product. The obtained precipitate was separated by decantation, the precipitate was dissolved again in THF, and methanol and THF remaining were distilled off with an evaporator. A desired polymer having an amide group (releasability-imparting agent, Mw = 24414, Mw/Mn = 2.8) was obtained.

### [Preparation Example 1-5]

A flask was charged with 15.00 g of both-terminal amino-modified silicone KF8008 (manufactured by Shin-Etsu Chemical Co., Ltd.), 0.69 g of heptanoic acid, and 39.02 g of THF as a solvent, and the mixture was stirred at room temperature for about 5 minutes, then 1.02 g of diisopropylcarbodiimide was added, and the mixture was stirred at room temperature for 22 hours. The reaction mixture was added dropwise to methanol and the product was reprecipitated. The obtained precipitate was separated by decantation, the precipitate was dissolved again in THF, and methanol and THF remaining were distilled off with an evaporator. A desired polymer having an amide group (releasability-imparting agent, Mw = 23591, Mw/Mn = 1.8) was obtained.

### [Preparation Example 1-6]

A flask was charged with 20.06 g of both-terminal amino-modified silicone KF8008 (manufactured by Shin-Etsu Chemical Co., Ltd.), 1.27 g of octanoic acid, and 35.16 g of THF as a solvent, and the mixture was stirred at room temperature for about 5 minutes, then 1.33 g of diisopropylcarbodiimide was added, and the mixture was stirred at room temperature for 26 hours. The reaction mixture was added dropwise to methanol and the product was reprecipitated. The obtained precipitate was separated by decantation, the precipitate was dissolved again in THF, and methanol and THF remaining were distilled off with an evaporator. A desired polymer having an amide group (releasability-imparting agent, Mw = 22137, Mw/Mn = 1.5) was obtained.

### [Preparation Example 1-7]

A flask was charged with 20.00 g of both-terminal amino-modified silicone KF8008 (manufactured by Shin-Etsu Chemical Co., Ltd.), 1.63 g of α-phenylcinnamic acid, and 53.70 g of THF as a solvent, and the mixture was stirred at room temperature for about 5 minutes, then 1.36 g of diisopropylcarbodiimide was added, and the mixture was stirred at room temperature for 21 hours. The reaction mixture was added dropwise to methanol and the product was reprecipitated. The obtained precipitate was separated by decantation, the precipitate was dissolved again in THF, and methanol and THF remaining were distilled off with an evaporator. A desired polymer having an amide group (releasability-imparting agent, Mw = 21444, Mw/Mn = 1.7) was obtained.

### [Preparation Example 1-8]

A flask was charged with 20.00 g of both-terminal amino-modified silicone KF8008 (manufactured by Shin-Etsu Chemical Co., Ltd.), 1.24 g of 2-naphthalenecarboxylic acid, and 52.70 g of THF as a solvent, and the mixture was stirred at room temperature for about 5 minutes, then 1.34 g of diisopropylcarbodiimide was added, and the mixture was stirred at room temperature for 21 hours. The reaction mixture was added dropwise to methanol and the product was reprecipitated. The obtained precipitate was separated by decantation, the precipitate was dissolved again in THF, and methanol and THF remaining were distilled off with an evaporator. A desired polymer having an amide group (releasability-imparting agent, Mw = 22092, Mw/Mn = 1.7) was obtained.

### [Preparation Example 1-9]

A flask was charged with 32.42 g of a 25 mass% THF solution of VPS-1001N (manufactured by FUJIFILM Wako Pure Chemical Corporation), 5.04 g of 2-vinylnaphthalene, and 37.80 g of THF as a solvent, and the mixture was stirred at room temperature for about 5 minutes and then stirred at 75°C for 18 hours. The reaction mixture was allowed to cool to room temperature, and then added dropwise to methanol to reprecipitate the product. The obtained precipitate was separated by decantation, the precipitate was dissolved again in THF, and methanol and THF remaining were distilled off with an evaporator. A desired polymer having an amide group (releasability-imparting agent, Mw = 78220, Mw/Mn = 2.4) was obtained.

### [Preparation Example 1-10]

A flask was charged with 32.50 g of a 25 mass% THF solution of VPS-1001N (manufactured by FUJIFILM Wako Pure Chemical Corporation), 5.03 g of acenaphthylene, and 48.50 g of THF as a solvent, and the mixture was stirred at room temperature for about 5 minutes and then stirred at 75°C for 18 hours. The reaction mixture was allowed to cool to room temperature, and then added dropwise to methanol to reprecipitate the product. The obtained precipitate was separated by decantation, the precipitate was dissolved again in THF, and methanol and THF remaining were distilled off with an evaporator. A desired polymer having an amide group (releasability-imparting agent, Mw = 44221, Mw/Mn = 1.9) was obtained.

### [Preparation Example 1-11]

A flask was charged with 32.45 g of a 25 mass% THF solution of VPS-1001N (manufactured by FUJIFILM Wako Pure Chemical Corporation), 8.34 g of 4-allyloxy-2-hydroxybenzophenone, and 42.64 g of THF as a solvent, and the mixture was stirred at room temperature for about 5 minutes and then stirred at 75°C for 24 hours. The reaction mixture was allowed to cool to room temperature, and then added dropwise to methanol to reprecipitate the product. The obtained precipitate was separated by decantation, the precipitate was dissolved again in THF, and methanol and THF remaining were distilled off with an evaporator. A desired polymer having an amide group (releasability-imparting agent, Mw = 59332, Mw/Mn = 2.0) was obtained.

### [Preparation Example 1-12]

A flask was charged with 21.30 g of a 25 mass% THF solution of VPS-1001N (manufactured by FUJIFILM Wako Pure Chemical Corporation), 7.00 g of 2-[2-hydroxy-5-[2-(methacryloyloxy)ethyl]phenyl]-2H-benzotriazole, and 28.70 g of THF as a solvent, and the mixture was stirred at room temperature for about 5 minutes and then stirred at 75°C for 24 hours. The reaction mixture was allowed to cool to room temperature, and then added dropwise to methanol to reprecipitate the product. The obtained precipitate was separated by decantation, the precipitate was dissolved again in THF, and methanol and THF remaining were distilled off with an evaporator. A desired polymer having an amide group (releasability-imparting agent, Mw = 70304, Mw/Mn = 2.05) was obtained.

### [2] Preparation of adhesive composition

### [Preparation Example 2-1]

In a 600 mL stirring vessel dedicated to a rotation and revolution mixer, 150 g of a base polymer composed of a vinyl group-containing linear polydimethylsiloxane having a viscosity of 200 mPa·s and represented by the following formula (V) and a vinyl group-containing MQ resin (manufactured by Wacker Chemie AG) as the component (a1), 15.81 g of an SiH group-containing linear polydimethylsiloxane having a viscosity of 100 mPa·s (manufactured by Wacker Chemie AG) as the component (a2), and 0.17 g of 1-ethynyl-1-cyclohexanol (manufactured by Wacker Chemie AG) as the component (A3) were charged and stirred with the stirrer A for 5 minutes to obtain a mixture (I).

In a 50 mL screw tube, 0.33 g of a platinum catalyst (manufactured by Wacker Chemie AG) as the component (A2) and 9.98 g of a vinyl group-containing linear polydimethylsiloxane having a viscosity of 1000 mPa·s and represented by the following formula (W) (manufactured by Wacker Chemie AG) as the component (a1) were stirred for 5 minutes with the rotation and revolution mixer to obtain a mixture (II).

To the mixture (I), 0.52 g of the obtained mixture (II) was added, and the mixture was stirred with the stirrer A for 5 minutes to obtain a mixture (III).

The finally obtained mixture (III) was filtered through a nylon filter 300 mesh to obtain an adhesive composition. The viscosity of the adhesive composition measured using the rotational viscometer was 9900 mPa·s. 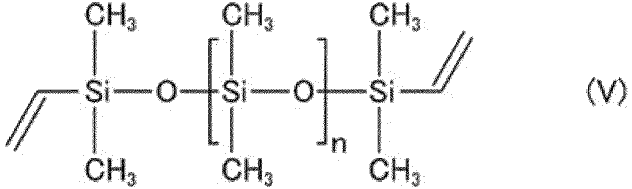 (n represents a repeating unit number
and is a positive integer.)

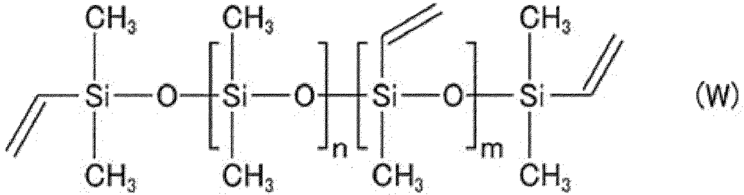

(Each of n and m represents a repeating
unit number and is a positive integer.)

### [Preparation Example 2-2]

In a 100 mL stirring vessel dedicated to a rotation and revolution mixer, 35.29 g of a p-menthane solution of a vinyl group-containing MQ resin (manufactured by Wacker Chemie AG) (concentration: 80.6 mass%) as the component (a1) and 0.13 g of 1,1-diphenyl-2-propyne-1-ol (manufactured by Tokyo Chemical Industry Co., Ltd.) as the component (A3) were added, and stirred with the stirrer A for 5 minutes to obtain a mixture (I).

To the obtained mixture (I), 7.52 g of a vinyl group-containing linear polydimethylsiloxane represented by the formula (V) and having a viscosity of 100,000 mPa·s (manufactured by Wacker Chemie AG) as the component (a1), 5.01 g of an SiH group-containing linear polydimethylsiloxane having a viscosity of 100 mPa·s (manufactured by Wacker Chemie AG) as the component (a2), and further 0.13 g of 1-ethynyl-1-cyclohexanol (manufactured by Wacker Chemie AG) as the component (A3) were added, and the mixture was stirred with the stirrer A for 10 minutes to obtain a mixture (II).

With the stirrer A, 0.03 g of a platinum catalyst (manufactured by Wacker Chemie AG) as the component (A2) and 11.26 g of a vinyl group-containing linear polydimethylsiloxane having a viscosity of 200 mPa·s and represented by the following formula (V) (manufactured by Wacker Chemie AG) as the component (a1) were stirred for 5 minutes to obtain a mixture (III).

To the mixture (II), 7.53 g of the obtained mixture (III) was added, and the mixture was stirred with the stirrer A for 5 minutes to obtain a mixture (IV).

Finally, the obtained mixture (IV) was filtered through a nylon filter 300 mesh to obtain an adhesive composition. The viscosity of the adhesive composition measured using the rotational viscometer was 1100 mPa·s.

### [3] Preparation of adhesive composition

### [Preparation Example 3-1]

In a 100 mL stirring vessel dedicated to a rotation and revolution mixer, 0.40 g of the releasability-imparting agent obtained in Preparation Example 1-1, 40.04 g of the adhesive composition obtained in Preparation Example 2-2, 0.10 g of 1,1-diphenyl-2-propyne-1-ol (manufactured by Tokyo Chemical Industry Co., Ltd.), and 0.80 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition. The viscosity of the adhesive composition measured using the rotational viscometer was 2700 mPa·s.

### [Preparation Example 3-2]

In a 100 mL stirring vessel dedicated to a rotation and revolution mixer, 0.41 g of the releasability-imparting agent obtained in Preparation Example 1-2, 40.07 g of the adhesive composition obtained in Preparation Example 2-1, 0.10 g of 1,1-diphenyl-2-propyne-1-ol (manufactured by Tokyo Chemical Industry Co., Ltd.), and 0.81 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition. The viscosity of the adhesive composition measured using the rotational viscometer was 3000 mPa·s.

### [Preparation Example 3-3]

In a 100 mL stirring vessel dedicated to a rotation and revolution mixer, 0.40 g of the releasability-imparting agent obtained in Preparation Example 1-3, 40.01 g of the adhesive composition obtained in Preparation Example 2-1, 0.10 g of 1,1-diphenyl-2-propyne-1-ol (manufactured by Tokyo Chemical Industry Co., Ltd.), and 0.80 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition. The viscosity of the adhesive composition measured using the rotational viscometer was 3000 mPa·s.

### [Preparation Example 3-4]

In a 100 mL stirring vessel dedicated to a rotation and revolution mixer, 0.40 g of the releasability-imparting agent obtained in Preparation Example 1-4, 40.03 g of the adhesive composition obtained in Preparation Example 2-1, 0.10 g of 1,1-diphenyl-2-propyne-1-ol (manufactured by Tokyo Chemical Industry Co., Ltd.), and 0.80 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition. The viscosity of the adhesive composition measured using the rotational viscometer was 2900 mPa·s.

### [Preparation Example 3-5]

In a 100 mL stirring vessel dedicated to a rotation and revolution mixer, 0.40 g of the releasability-imparting agent obtained in Preparation Example 1-5, 40.04 g of the adhesive composition obtained in Preparation Example 2-2, 0.10 g of 1,1-diphenyl-2-propyne-1-ol (manufactured by Tokyo Chemical Industry Co., Ltd.), and 0.80 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition. The viscosity of the adhesive composition measured using the rotational viscometer was 2700 mPa·s.

### [Preparation Example 3-6]

In a 100 mL stirring vessel dedicated to a rotation and revolution mixer, 0.40 g of the releasability-imparting agent obtained in Preparation Example 1-6, 40.01 g of the adhesive composition obtained in Preparation Example 2-1, 0.10 g of 1,1-diphenyl-2-propyne-1-ol (manufactured by Tokyo Chemical Industry Co., Ltd.), and 0.81 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition. The viscosity of the adhesive composition measured using the rotational viscometer was 2800 mPa·s.

### [Preparation Example 3-7]

In a 100 mL stirring vessel dedicated to a rotation and revolution mixer, 0.40 g of the releasability-imparting agent obtained in Preparation Example 1-7, 40.03 g of the adhesive composition obtained in Preparation Example 2-1, 0.10 g of 1,1-diphenyl-2-propyne-1-ol (manufactured by Tokyo Chemical Industry Co., Ltd.), and 0.81 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition. The viscosity of the adhesive composition measured using the rotational viscometer was 2700 mPa·s.

### [Preparation Example 3-8]

In a 100 mL stirring vessel dedicated to a rotation and revolution mixer, 0.41 g of the releasability-imparting agent obtained in Preparation Example 1-8, 40.03 g of the adhesive composition obtained in Preparation Example 2-1, 0.10 g of 1,1-diphenyl-2-propyne-1-ol (manufactured by Tokyo Chemical Industry Co., Ltd.), and 0.81 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition. The viscosity of the adhesive composition measured using the rotational viscometer was 2700 mPa·s.

### [Preparation Example 3-9]

In a 100 mL stirring vessel dedicated to a rotation and revolution mixer, 0.40 g of the releasability-imparting agent obtained in Preparation Example 1-9, 40.00 g of the adhesive composition obtained in Preparation Example 2-1, 0.10 g of 1,1-diphenyl-2-propyne-1-ol (manufactured by Tokyo Chemical Industry Co., Ltd.), and 0.81 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition.

### [Preparation Example 3-10]

In a 100 mL stirring vessel dedicated to a rotation and revolution mixer, 0.40 g of the releasability-imparting agent obtained in Preparation Example 1-10, 40.00 g of the adhesive composition obtained in Preparation Example 2-1, 0.10 g of 1,1-diphenyl-2-propyne-1-ol (manufactured by Tokyo Chemical Industry Co., Ltd.), and 0.81 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition.

### [Preparation Example 3-11]

In a 100 mL stirring vessel dedicated to a rotation and revolution mixer, 0.41 g of the releasability-imparting agent obtained in Preparation Example 1-11, 40.04 g of the adhesive composition obtained in Preparation Example 2-1, 0.10 g of 1,1-diphenyl-2-propyne-1-ol (manufactured by Tokyo Chemical Industry Co., Ltd.), and 0.80 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition.

### [Preparation Example 3-12]

In a 100 mL stirring vessel dedicated to a rotation and revolution mixer, 0.40 g of the releasability-imparting agent obtained in Preparation Example 1-12, 40.02 g of the adhesive composition obtained in Preparation Example 2-1, 0.10 g of 1,1-diphenyl-2-propyne-1-ol (manufactured by Tokyo Chemical Industry Co., Ltd.), and 0.82 g of p-menthane (manufactured by Nippon Terpene Chemicals, Inc.) as a solvent were added, and stirred with the stirrer A for 10 minutes to obtain a mixture (I). The obtained mixture (I) was filtered through a nylon filter 300 mesh to obtain an adhesive composition.

### [Comparative Preparation Examples 3-1 to 3-14]

In the rotation and revolution mixer, 20 g of the adhesive composition obtained in Preparation Example 2-1 and a polyorganosiloxane represented by the following formula (M1) (manufactured by Wacker Chemie AG) shown in Table 1 in the ratio shown in Table 1 with respect to 100 parts by mass of the adhesive composition obtained in Preparation Example 2-1 were added, and the mixture was stirred with the stirrer A for 10 minutes to obtain a mixture (I). The obtained mixture (I) was filtered through a nylon filter 300 mesh to obtain an adhesive composition. 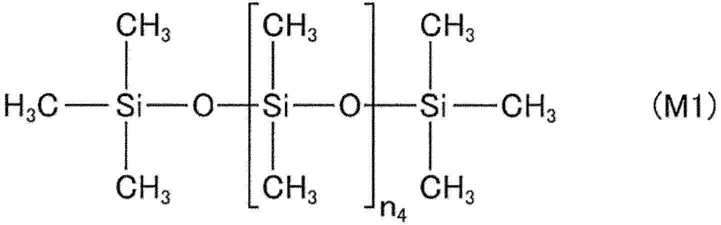 (n₄ represents a repeating unit number and is a positive integer.)

**[Table 1]**

| Comparative Preparation Example | | 3-1 | 3-2 | 3-3 | 3-4 | 3-5 | 3-6 | 3-7 | 3-8 | 3-9 | 3-10 | 3-11 | 3-12 | 3-13 | 3-14 |
|---|---|---|---|---|---|---|---|---|---|---|---|---|---|---|---|
| Polyorganosiloxane | Trade name | AK50 | | | AK350 | | | AK1000 | | | AK10000 | | | AK1M | |
| | Mw | 7120 | | | 21100 | | | 34550 | | | 69980 | | | 171900 | |
| Amount (parts by mass) | | 1 | 10 | 20 | 1 | 10 | 20 | 1 | 10 | 20 | 1 | 10 | 20 | 20 | 45 |

In Table 1, "AK50" and the like are trade names of polyorganosiloxanes manufactured by Wacker Chemie AG.

### [Comparative Preparation Examples 3-15 to 3-22]

In the rotation and revolution mixer, 15 g of the adhesive composition obtained in Preparation Example 2-1 and a both-terminal modified silicone (manufactured by Shin-Etsu Chemical Co., Ltd.) shown in Tables 2-1 or 2-2 in an amount of 1 part by mass with respect to 100 parts by mass of the adhesive composition obtained in Preparation Example 2-1 were added, and the mixture was stirred with the stirrer A for 10 minutes to obtain a mixture (I). The obtained mixture (I) was filtered through a nylon filter 300 mesh to obtain an adhesive composition.

**[Table 2-1]**

| Comparative Preparation Example | 3-15 | 3-16 | 3-17 | 3-18 |
|---|---|---|---|---|
| Both-terminal modified silicone | KF105 | KF2201 | KF6003 | KF8008 |
| Terminal functional group | 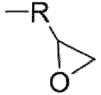 | 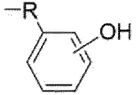 | 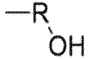 | 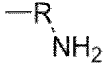 |

**[Table 2-2]**

| Comparative Preparation Example | 3-19 | 3-20 | 3-21 | 3-22 |
|---|---|---|---|---|
| Both-terminal modified silicone | KF8010 | X-21-5841 | X-22-162C | X-22-163C |
| Terminal functional group | 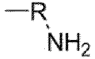 | -OH | 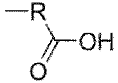 | 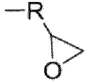 |

In Tables 2-1 and 2-2, "KF105" and the like are trade names of both-terminal modified silicones manufactured by Shin-Etsu Chemical Co., Ltd.

### [4] Preparation of release agent composition

### [Preparation Example 4]

In a flask, 56.02 g of N-phenyl-1-naphthylamine, 50.00 g of 1-pyrenecarboxaldehyde, 6.67 g of 4-(trifluoromethyl) benzaldehyde, and 2.46 g of methanesulfonic acid were charged, 86.36 g of 1,4-dioxane and 86.36 g of toluene were added thereto, and the mixture was refluxed and stirred for 18 hours under a nitrogen atmosphere.

The reaction mixture was allowed to cool, then diluted by adding 96 g of tetrahydrofuran, and the obtained diluted solution was added dropwise to methanol to obtain a precipitate. The obtained precipitate was recovered by filtration, and the filtrate was washed with methanol, and dried at 60°C under reduced pressure to obtain 72.12 g of a novolac resin.

The weight average molecular weight of the novolac resin as a polymer measured in terms of polystyrene by GPC was 1,100.

In 95.58 g of propylene glycol monomethyl ether acetate, 3.6 g of the obtained novolac resin, 0.72 g of a compound represented by the following formula (L) (trade name: TMOM-BP, manufactured by Honshu Chemical Industry Co., Ltd.) as a crosslinking agent, and 0.1 g of pyridinium paratoluenesulfonate were dissolved, and the obtained solution was filtered using a polyethylene microfilter having a pore size of 0.2 µm to obtain a release agent composition.

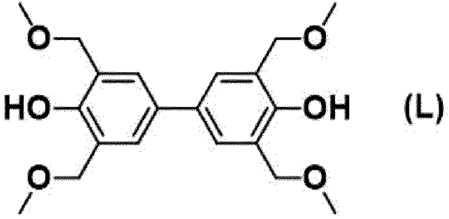

### [5] Evaluation of removability of adhesive layer

### [Examples 1-1 to 1-18 and Comparative Examples 1-1 to 1-24]

The removability of the adhesive layer obtained from the adhesive composition was evaluated. The removability was evaluated by immersing the adhesive layer in an arbitrary organic solvent and visually checking whether or not the adhesive layer floated.

The adhesive composition obtained in each of Preparation Examples 3-1 to 3-12, Comparative Preparation Examples 3-1 to 3-22, and Preparation Examples 2-1 to 2-2 was applied to a silicon wafer chip cut into 4 × 4 cm with a spin coater, and heated at 200°C for 10 minutes to form an adhesive layer (thickness: 60 µm). Thereafter, the silicon wafer chip on which the adhesive layer was formed was placed in a stainless steel petri dish having a diameter of 9 cm, and 10 mL of an organic solvent (n-decane, or dibutyl ether (di-n-butyl ether), or mesitylene) was added thereto. After standing for 5 minutes, the silicon wafer chip was washed with isopropanol, and it was confirmed whether the adhesive layer was removed. A case where the adhesive layer was not removed at all even after 5 minutes of immersion in the solvent was evaluated as "×", a case where a part of the adhesive layer was removed after 5 minutes was evaluated as "△", and a case where the entire adhesive layer was removed within 5 minutes was evaluated as "○".

**[Table 3]**

| Example | Adhesive layer | Organic solvent | Removability |
|---|---|---|---|
| Example 1-1 | Preparation Example 3-1 | n-Decane | ○ |
| Example 1-2 | Preparation Example 3-2 | n-Decane | ○ |
| Example 1-3 | Preparation Example 3-3 | n-Decane | ○ |
| Example 1-4 | Preparation Example 3-4 | n-Decane | ○ |
| Example 1-5 | Preparation Example 3-5 | n-Decane | ○ |
| Example 1-6 | Preparation Example 3-5 | Dibutyl ether | ○ |
| Example 1-7 | Preparation Example 3-5 | Mesitylene | △ |
| Example 1-8 | Preparation Example 3-6 | n-Decane | ○ |
| Example 1-9 | Preparation Example 3-7 | n-Decane | △ |
| Example 1-10 | Preparation Example 3-7 | Dibutyl ether | △ |
| Example 1-11 | Preparation Example 3-7 | Mesitylene | ○ |
| Example 1-12 | Preparation Example 3-8 | n-Decane | △ |
| Example 1-13 | Preparation Example 3-8 | Dibutyl ether | △ |
| Example 1-14 | Preparation Example 3-8 | Mesitylene | ○ |
| Example 1-15 | Preparation Example 3-9 | n-Decane | ○ |
| Example 1-16 | Preparation Example 3-10 | n-Decane | ○ |
| Example 1-17 | Preparation Example 3-11 | n-Decane | ○ |
| Example 1-18 | Preparation Example 3-12 | n-Decane | ○ |

**[Table 4]**

| Comparative Example | Adhesive layer | Organic solvent | Removability |
|---|---|---|---|
| Comparative Example 1-1 | Comparative Preparation Example 3-1 | n-Decane | × |
| Comparative Example 1-2 | Comparative Preparation Example 3-2 | n-Decane | × |
| Comparative Example 1-3 | Comparative Preparation Example 3-3 | n-Decane | × |
| Comparative Example 1-4 | Comparative Preparation Example 3-4 | n-Decane | × |
| Comparative Example 1-5 | Comparative Preparation Example 3-5 | n-Decane | × |
| Comparative Example 1-6 | Comparative Preparation Example 3-6 | n-Decane | × |
| Comparative Example 1-7 | Comparative Preparation Example 3-7 | n-Decane | × |
| Comparative Example 1-8 | Comparative Preparation Example 3-8 | n-Decane | × |
| Comparative Example 1-9 | Comparative Preparation Example 3-9 | n-Decane | × |
| Comparative Example 1-10 | Comparative Preparation Example 3-10 | n-Decane | × |
| Comparative Example 1-11 | Comparative Preparation Example 3-11 | n-Decane | × |
| Comparative Example 1-12 | Comparative Preparation Example 3-12 | n-Decane | × |
| Comparative Example 1-13 | Comparative Preparation Example 3-13 | n-Decane | × |
| Comparative Example 1-14 | Comparative Preparation Example 3-14 | n-Decane | × |
| Comparative Example 1-15 | Comparative Preparation Example 3-15 | n-Decane | × |
| Comparative Example 1-16 | Comparative Preparation Example 3-16 | n-Decane | × |
| Comparative Example 1-17 | Comparative Preparation Example 3-17 | n-Decane | × |
| Comparative Example 1-18 | Comparative Preparation Example 3-18 | n-Decane | × |
| Comparative Example 1-19 | Comparative Preparation Example 3-19 | n-Decane | × |
| Comparative Example 1-20 | Comparative Preparation Example 3-20 | n-Decane | × |
| Comparative Example 1-21 | Comparative Preparation Example 3-21 | n-Decane | × |
| Comparative Example 1-22 | Comparative Preparation Example 3-22 | n-Decane | × |
| Comparative Example 1-23 | Preparation Example 2-1 | n-Decane | × |
| Comparative Example 1-24 | Preparation Example 2-2 | n-Decane | × |

### [6] Adhesion test

### [6-1] Preparation of laminate

### [Example 2-1]

The adhesive composition obtained in Preparation Example 3-1 was spin-coated on a 100 mm silicon wafer (thickness: 770 µm) as a device-side wafer (semiconductor substrate), and heated (preheated) at 120°C for 1.5 minutes to form an adhesive coating layer on the circuit surface of the silicon wafer so that the adhesive layer had a final thickness of about 60 um in the laminate.

On the other hand, the release agent composition obtained in Preparation Example 4 was applied to a 100 mm glass wafer (thickness: 500 µm) as a carrier side wafer (support substrate) by spin coating, and heated at 250°C for 5 minutes to form a release layer on the glass wafer so that the release layer has a final thickness of about 200 nm in the laminate.

Thereafter, in the vacuum bonding apparatus, the semiconductor substrate and the support substrate were bonded so as to sandwich the adhesive coating layer and the release layer, and heated on a hot plate at 200°C for 10 minutes with the semiconductor substrate side facing down (post-heat treatment) to prepare a laminate. Bonding was performed at a temperature of 23°C and a vacuum degree of 1,000 Pa.

### [Example 2-2]

A laminate was prepared in the same manner as in Example 2-1, except that the adhesive composition obtained in Preparation Example 3-5 was used in place of the adhesive composition obtained in Preparation Example 3-1.

### [6-2] Evaluation of adhesiveness

The adhesiveness was evaluated by visually checking if there were voids from the glass wafer (support substrate) side of the laminate.

A case where no void was confirmed was evaluated as good, and a case where voids were confirmed was evaluated as poor.

As a result, no void was confirmed in each of the laminates obtained in Examples 2-1 and 2-2.

### [6-3] Evaluation of laser releasability

Using the laser irradiation device, the release layer was irradiated with a laser having a wavelength of 308 nm at 320 mJ/cm² from the glass wafer side of the fixed laminate. Then, the support substrate was manually lifted to check if the support substrate can be released. As a result, in each of the laminates obtained in Examples 2-1 and 2-2, the support substrate was successfully released without a load by lifting.

### Reference Signs List

- 1: Wafer
- 2: Adhesive layer
- 2a: Adhesive coating layer
- 3: Release layer
- 4: Support substrate
- 12: Coating device
- 13: Heating device

## Claims

1. An adhesive composition comprising a polymer having an amide bond and a polyorganosiloxane structure.

2. The adhesive composition according to claim 1, wherein the polymer has the amide bond in a main chain.

3. The adhesive composition according to claim 1, wherein the polymer has the polyorganosiloxane structure in a main chain.

4. The adhesive composition according to claim 1,
wherein the polyorganosiloxane structure is represented by a formula (1) below: 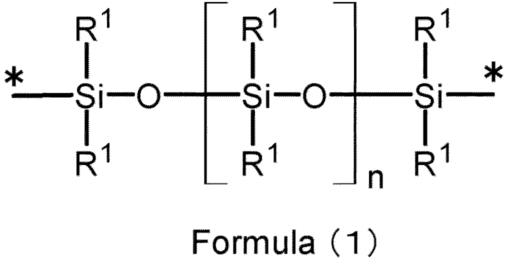
wherein, in the formula (1), R¹ each independently represents an alkyl group having 1 to 4 carbon atoms or a phenyl group, n represents a repeating unit number and is a positive integer, and * represents a bonding hand.

5. The adhesive composition according to claim 4, wherein, in the formula (1), R¹ represents a methyl group.

6. The adhesive composition according to claim 1, further comprising an adhesive component.

7. The adhesive composition according to claim 6, wherein the adhesive component includes a component that is cured by hydrosilylation reaction.

8. The adhesive composition according to claim 7, wherein the component that is cured by hydrosilylation reaction includes a polyorganosiloxane component that is cured by hydrosilylation reaction.

9. The adhesive composition according to claim 8, wherein
the polyorganosiloxane component that is cured by hydrosilylation reaction includes:
a polyorganosiloxane (a1) having an alkenyl group bonded to a silicon atom and having 2 to 40 carbon atoms;
a polyorganosiloxane (a2) having an Si-H group; and
a platinum group metal-based catalyst (A2).

10. A laminate comprising: an adhesive layer interposed between a semiconductor substrate and a support substrate and in contact with the semiconductor substrate, wherein
the adhesive layer is formed from the adhesive composition according to any one of claims 1 to 9.

11. The laminate according to claim 10, comprising: a release layer interposed between the semiconductor substrate and the support substrate and in contact with the support substrate and the adhesive layer.

12. A method for producing a semiconductor substrate, the method comprising:
a step of processing the semiconductor substrate in the laminate according to claim 10; and
a step of separating the support substrate and the processed semiconductor substrate from each other.

13. A method for producing the laminate according to claim 10, the method comprising:
a step of forming an adhesive coating layer that provides the adhesive layer; and
a step of heating the adhesive coating layer to form the adhesive layer.

14. A releasability-imparting agent used in an adhesive composition,
the releasability-imparting agent being a polymer having an amide bond and a polyorganosiloxane structure.

15. The releasability-imparting agent according to claim 14, wherein the polymer has the amide bond in a main chain.

16. The releasability-imparting agent according to claim 14, wherein the polymer has the polyorganosiloxane structure in a main chain.

17. The releasability-imparting agent according to any one of claims 14 to 16, wherein the polyorganosiloxane structure is represented by a formula (1) below: 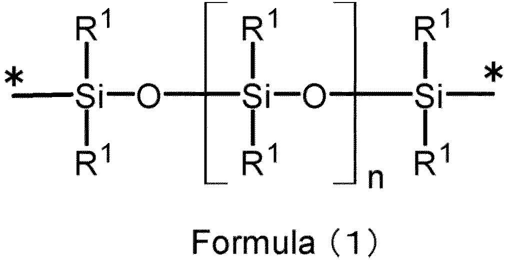 wherein, in the formula (1), R¹ each independently represents an alkyl group having 1 to 4 carbon atoms or a phenyl group, n represents a repeating unit number and is a positive integer, and * represents a bonding hand.

18. The releasability-imparting agent according to claim 17, wherein, in the formula (1), R¹ represents a methyl group.
